(19) Europäisches Patentamt
European Patent Office
Office européen des brevets

(11) **EP 2 814 176 A1**

(12) **EUROPEAN PATENT APPLICATION**

(43) Date of publication:
**17.12.2014 Bulletin 2014/51**

(51) Int Cl.:
***H03L 7/099*** *(2006.01)* ***H03L 7/10*** *(2006.01)*
***H03L 7/107*** *(2006.01)*

(21) Application number: **13305780.2**

(22) Date of filing: **10.06.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Asahi Kasei Microdevices Corporation Tokyo 101-8101 (JP)**

(72) Inventors:
• **Jovenin, Fabrice**
  **14460 Colombelles (FR)**
• **Morand, Cedric**
  **14460 Colombelles (FR)**

(74) Representative: **Cabinet Plasseraud**
**52, rue de la Victoire**
**75440 Paris Cedex 09 (FR)**

(54) **Fast lock phase-locked loop**

(57)      There is disclosed a fast lock PLL integrated circuit (1) implementing a phase error reduction sequence during a wide bandwidth mode of operation of a loop filter module (108) of the PLL, which sequence includes reducing KVCO parameter of a VCO module (110) of the PLL. Since such control of the phase/frequency of the output signal of the VCO does not depend on current mismatch in e.g. a charge pump (106) of the PLL, a fast lock with low phase noise error can be achieved without requiring a complex mismatch cancellation system occupying a large die area.

FIG. 2

## Description

**Technical Field**

The present invention generally relates to Phase-Locked-Loop (PLL) structures, and more particularly to methods and devices for obtaining fast lock of such PLL structures.

**Related Art**

The approaches described in this section could be pursued, but are not necessarily approaches that have been previously conceived or pursued. Therefore, unless otherwise indicated herein, the approaches described in this section are not prior art to the claims in this application and are not admitted to be prior art by inclusion in this section.

Many electronic circuits and devices, such as for instance GPS devices, cellular terminals and base stations, TV receivers and other similar digital appliances, require an internal clock signal with a constant clock frequency. Said clock frequency must be as stable as possible in spite of, for instance, temperature variations yielding in phase/frequency deviations. A clock signal generator should be able to automatically correct these phase/frequency drifts at any time, including time when the setting changes are being performed.

Generally, Phase-Locked-Loops (PLL) structures are used to provide clock circuits. PLL structures comprise several blocks or modules including, in the example of an analog PLL, a Voltage Control Oscillator (VCO), a Charge Pump (CP) module, a loop filter and a frequency divider module arranged in a feedback path of the PLL and adapted to generate a divided frequency clock signal from the VCO output signal. The performance of any PLL structure is determined by the speed of the PLL locking, in addition to the precision of the output frequency.

For analog PLL structures, fast lock may be obtained thanks to a combination of switching of the loop filter from a wide bandwidth configuration to a narrow bandwidth configuration, with switching of the charge pump current from higher current values to lower current values. Indeed, the loop filter bandwidth is proportional to:

$$LoopFilterBandwidth \propto \sqrt{\frac{KVCO \times ICP}{C1 \times M}} \quad \textbf{(1)}$$

where:

KVCO is the VCO gain in Hz/V;
ICP is the Charge Pump current in Amps;
M is the feedback divider ratio; and,
C1 is the large LPF capacitor.

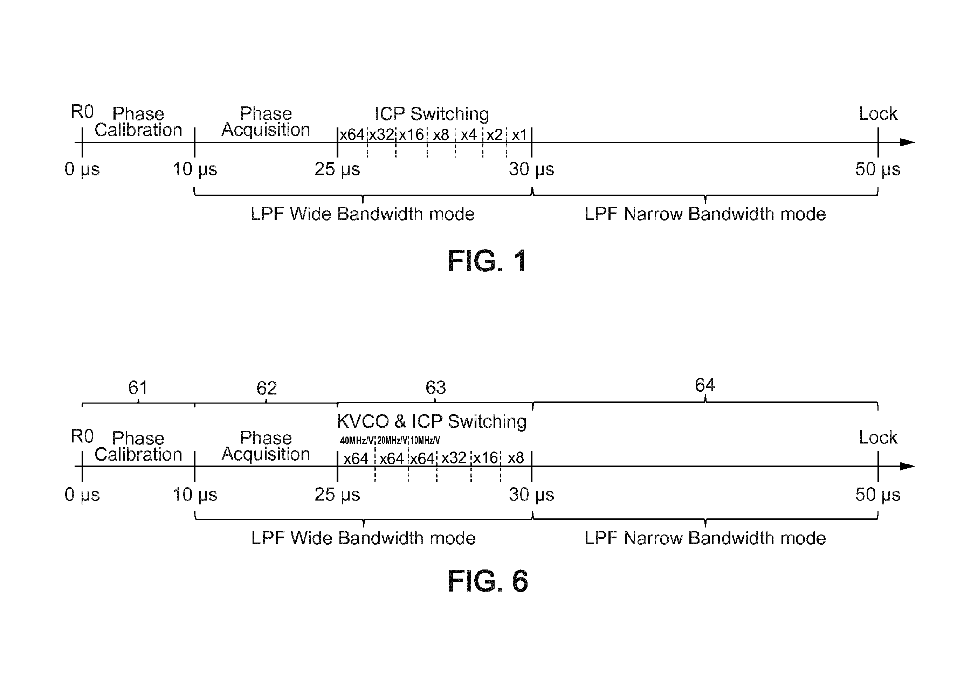

The wide bandwidth configuration of the loop filter needs a high CP current to avoid long time spent on charging loop filter capacitors, and the narrow bandwidth configuration needs a low CP current for stability reasons. The CP current switching (ICP Switching) may be based on reducing progressively, namely step-by-step, the CP current within a CP timing sequence. For instance, at each step of the CP timing sequence, the CP current may be divided by two. This factor of 2 simplifies the design, and also the compensation needed at level of a Sigma-Delta (SD) modulator used for modulating the divider ratio M. A typical phase error correction sequence is shown, for example, in the timing diagram of **FIG.1.**

Charge pump circuits are widely used in Analog PLL for low cost Integrated Circuits (IC) solutions. Unfortunately, the use of MOS transistors in conventional charge pump circuits generates some current mismatch due, in particular, to the difference between the drain-source voltages of the transistors. This current mismatch stems from the intrinsic nature of the components and the internal circuitry of known charge pump circuits. It leads to phase offsets and possibly also frequency jumps, resulting in phase/frequency noise in the PLL output signal, thereby reducing the actual locking range of the PLL.

Thus, in order to get a minimum lock time without reducing the PLL locking range it may be necessary to design a very complex charge pump current mismatch cancellation system.

However, such a mismatch cancellation system strongly increases electrical consumption of the charge pump circuit and adds surface constraints for the design of PLL structures, since a larger die area is needed.

Thus, in order to conserve the size of the PLL devices and their electrical consumption there is still a need for improved fast lock PLL structures. In particular, it is desirable to eliminate the need for a charge pump mismatch cancellation system.

US Patent No. 7,940,129 discloses a low KVCO Phase-Locked Loop with a large frequency drift handling capability.

US Patent No. 8,149,065 discloses using switchable varactors in a VCO to maintain fix value of KVCO over a large frequency range.

## SUMMARY

To present invention achieves the above goal by providing an alternative solution for fast lock PLL structures which is based on a KVCO control sequence.

More precisely, in a first aspect, there is proposed a Phase-Locked-Loop, PLL, integrated circuit, comprising:

- a Voltage-Controlled Oscillator, VCO module, adapted to generate an output signal of the PLL structure having an output frequency with respect to a VCO control signal,
- a frequency divider adapted to generate a feedback signal from the output signal, said feedback signal having a divided frequency with respect to the output frequency,
- a reference clock generator adapted to generate a reference clock signal with a reference frequency,
- a phase/frequency comparator having:

    - a first input for receiving the reference clock signal from the reference clock generator,
    - a second input for receiving the feedback signal from the frequency divider,
    - an output adapted to generate a frequency error signal with respect to a frequency error between the reference clock signal and the feedback signal,

- a loop filter adapted to generate a VCO control signal suitable for controlling the VCO, with respect to the frequency error signal,
  wherein:

    - the loop filter is adapted to be operated in a first mode of operation wherein the loop filter has a wider frequency bandwidth and then in a second mode of operation wherein the loop filter has a narrower frequency bandwidth, and,
    - the VCO comprises a setting module adapted to set a slope of a frequency response of the VCO to a first slope value in a first step of the first mode of operation of the loop filter, and at least to a second slope value in a second step of the first mode of operation of the loop filter, said second step coming after, i.e. following said first step in a phase error reduction sequence, and said second slope value being lower than said first slope value.

The proposed solution as defined above allows eliminating the need for an analog charge pump calibration system to remove process mismatch which is required by known solutions based on ICP switching. Unlike these known solutions which show constraints in the analog domain, the proposed solution is based on KVCO switching which require an accurate VCO calibration scheme which is operated in the digital domain, and thus is not affected by process mismatch.

## BRIEF DESCRIPTION OF THE DRAWINGS

Embodiments of the present invention are illustrated by way of example, and not by way of limitation, in the figures of the accompanying drawings, in which like reference numerals refer to similar elements, and in which:

- FIG.1 is a typical timing sequence of a PLL according to the prior art;

- FIG.2 is a simplified block diagram of a PLL circuit embodying the proposed solution,

- FIG.3 shows a possible structure of configurable loop filter used in the PLL of FIG.2;

- FIG.4 is a schematic representation of parts of a KVCO control module according to embodiments;

- FIG.5 is a diagram of showing several slope values for the VCO using the KVCO control module of FIG.4,

- FIG.6 is a timing diagram of the KVCO control sequence according to embodiments;

- FIG.7 shows a zoom on one phase of the KVCO control sequence of FIG.6 during which the KVCO parameter of the VCO is varied according to the teaching of the proposed solution.

**DESCRIPTION OF PREFERRED EMBODIMENTS**

Embodiments as described herein are directed to a fast lock Phase Locked Loop (PLL) structure, which is based on a control sequence of the slope of the frequency response of the Voltage-Controlled oscillator (VCO), named the KVCO parameter, implemented for locking the PLL within a phase of operation wherein the loop filter is operated in a wide bandwidth mode, as compared to the narrow bandwidth mode of operation in which the loop filter is configured to operate as the PLL locks to the desired frequency and phase.

The proposed solution for a fast lock PLL uses a VCO setting module, also referred to in what follows as a KVCO setting module, or just KVCO module. The proposed KVCO module implements a phase error correction sequence having steps in which different slope values of the frequency response of the VCO, namely of the KVCO parameter, are set.

In varying embodiments, the sequence may further enable to regulate the VCO output frequency by varying the current ICP of a Charge Pump (CP) module used as phase/frequency comparator of the PLL, in addition to varying the slope values of the VCO response, still during the wide bandwidth mode of operation of the loop filter.

As will be described in further details below, a fast lock PLL is achieved based on a phase error correction sequence which includes varying the KVCO parameter. In one embodiment, said phase error correction sequence includes firstly a variation of a KVCO slope for correcting a first phase shift between the frequency of the input signal of the PLL and the output signal of the VCO module 110, then followed secondly by a variation of a current ICP used in the CP module 106 which enables to reduce and to maintain a low phase shift between the two input signals of the phase/frequency comparator of the PLL circuit.

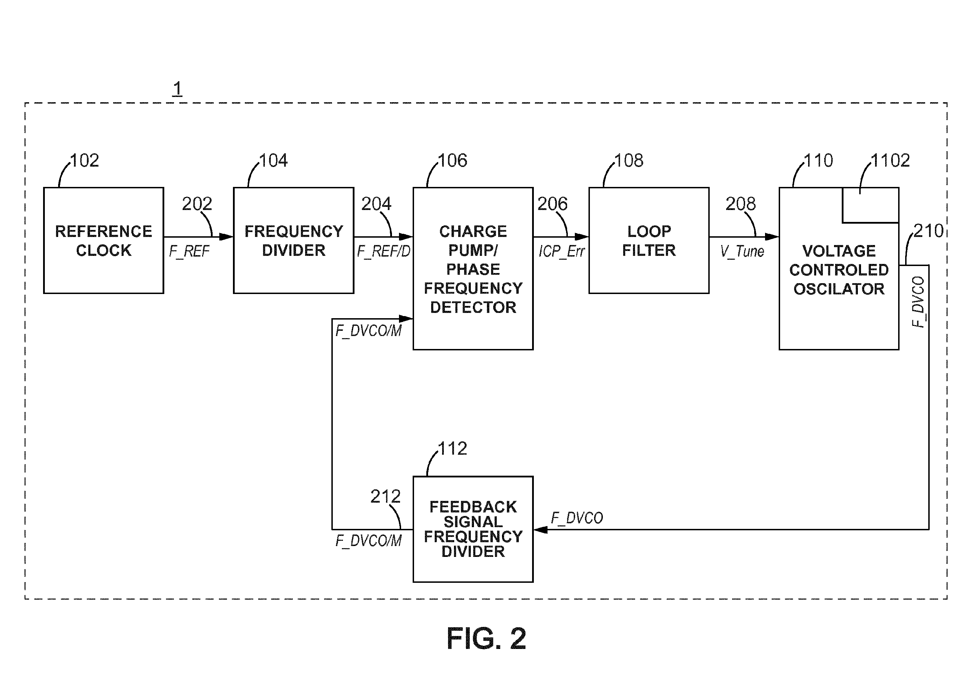

Referring to **FIG.2,** there is shown therein a simplified block diagram of a PLL circuit 1, to which embodiments of the invention can be applied. The proposed phase error correction sequence which will now be presented, may be run upon start-up of the PLL circuit, and/or upon change of the setting of the PLL, for instance of the frequency of the PLL output signal.

The PLL circuit 1 comprises a VCO module 110, for instance a digital VCO (also known as DVCO in the technical field).

The example PLL circuit 1 as shown may include a Reference Clock (RC) module 102 *e.g.*, a crystal oscillator, which is adapted to provide a reference clock signal 202 with a fixed and stable frequency. This reference clock signal is named F_REF in what follows and in the drawings.

A Frequency Divider module (FD) may be further arranged, at the output of the RC module 102 for dividing the frequency of the reference signal F_REF by a predetermined divider value D, where D may be an integer. Said FD module 104 is adapted to generate a reference clock signal 204 named F_REF/D in the following description and in the drawings, with a controllable but yet stable frequency. In some applications, the frequency of the output signal of the PLL may be varied by controlling the value of the divider ratio D of the FD module 104.

The PFD & CP module 106 is adapted to compare the respective frequency of two signals, namely the reference signal F_REF/D from the FD module 104 and another signal 212 named F_DVCO/M, which is issued from an output of the FSFD module 112 arranged in the feedback path of the PLL circuit 1. Said PFD & CP module 106 is adapted to generate an output current which is an image of frequency/phase error between the two inputs signal 206, named ICP_Err,. The PFD & CP module 106 allows amplifying the frequency/phase error signal ICP_Err by a programmable amplification gain β, with respect to a programmable CP current ICP of the CP module 106.

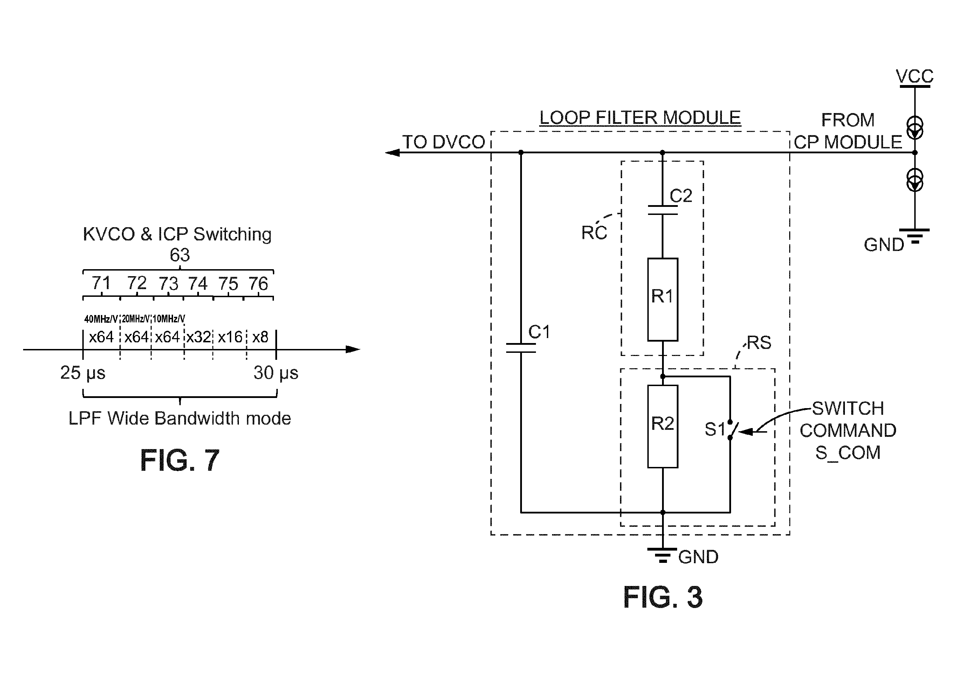

A Loop Filter (LF) module 108 of the PLL circuit 1 is adapted to low pass filter the analog signal ICP_Err received from the CP module 106, and to generate a smoothed output signal 208 named VTune, suitable for controlling the VCO module 110. An example of an internal structure of a LF module will be described in further details below, with reference to the circuit diagram of FIG.3. The VCO module 110 is adapted to receive in input the signal VTune from the LF module 108 and to generate a synthesized clock signal, namely the output signal 210 of the PLL circuit 1.

The FSFD module 112 is adapted to receive a signal from the output of the DVCO module 110 and to generate the signal 212 named F_DVCO/M, whose frequency is a multiple of the frequency of the output signal from the DVCO module.

The internal structure of the LF module 108 enables it to be operated in either one of two modes of operations, with respective frequency bandwidths: one with a comparatively wide bandwidth and a second with a comparatively narrow bandwidth. The principle of a double cut-off frequency of the LF module allows to reduce and to master among others the phase noise of the PLL structure by selecting the narrow bandwidth filter configuration when the PLL is locked.

A possible embodiment of the LF module 108 is shown, for instance, in **FIG.3.**

In the shown embodiment, the LF module 108 comprises a first capacitor C1 arranged between a DC voltage issued from the output of the CP module 106 and the ground GND. Capacitor C1 is connected in parallel with two serially connected modules. A first module, named RC module, comprises at least one second capacitor C2 connected in series with at least one first resistor R1. A second module named RS is connected in series with the RC module, for instance on the ground side. The RS module comprises at least one second resistor R2 and a switch S1 in parallel with R2 and which is controlled by a control signal S_COM. The state ON or OFF of the switch S1 triggers the operation on the LF module 108 in the wide or narrow bandwidth mode, respectively. Indeed, when the switch S1 is put in the ON state starting from the OFF state, the resistance R2 is short circuited, which shifts the filter cut-off frequency higher in the frequency band, and thus activates the wide bandwidth mode of the LF module 108.

The values of all components of the LF module 108 may be chosen so that both the wide bandwidth value and narrow bandwidth value correspond to the desired operating frequencies of the PLL. The switch S1 may be a MOS transistor used in switching mode exclusively, thereby obtaining a fast switching speed and a low leakage current in the OFF state. However, switch S1 can be realized with other types of transistor such as bipolar transistors or any other electronic components.

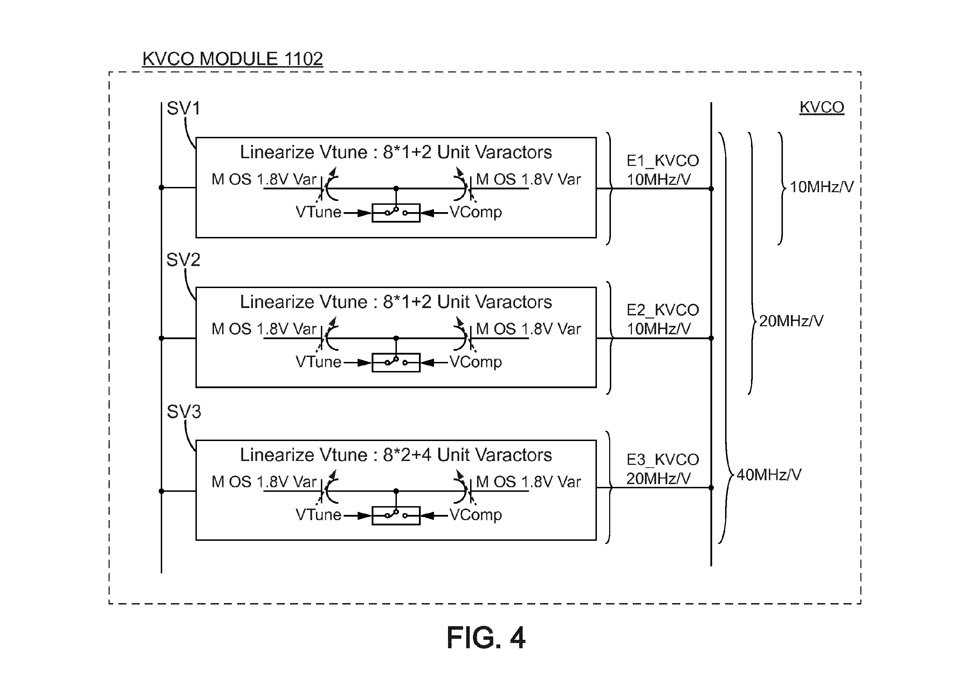

**FIG.4** is a partial diagram of the KVCO module 1102 of the VCO module 110. The KVCO module 1102 is designed for converting the frequency error signal ICP_Err, as output by the CP module 106 into a filtered and voltage converted by the LF module 108, into a frequency variation of the VCO module 110.

In the shown example, such conversion is performed by the KVCO module 1102 by using several Switchable Varactors (SV) modules able to generate several slope values of the frequency response of the VCO module 110.

The KVCO module 1102 comprises several SV modules like modules SV1, SV2 and SV3 as shown. It will be appreciated by the one with ordinary skills in the art that embodiments are not intended to be limited by the number, design or characteristics of SV modules. In the shown example, SV modules SV1, SV2 and SV3 are connected in parallel between a first and a second rails represented as vertical lines, on the left and right hand side, respectively, of the FIG.4. They may be connected in parallel with another, fixed analog varactor (not shown). The fixed analog varactor can be integrated in the VCO module 110 or it can be an external varactor connected between two pins of the VCO module 110 provided for this purpose.

The slope value S_KVCO of the frequency response of the VCO module 110 is governed by the following formula, assuming that the number of SV modules is N:

$$S\_KVCO = \Sigma \{ES1\_KVCO + ES2\_KVCO + .... + ESN\_KVCO\} \qquad (2)$$

where:

-    S_KVCO is the slope of KVCO signal;
-    ES1_KVCO is the elementary slope contribution generated by the first SV module;
-    ES2_KVCO is the elementary slope contribution generated by the second SV module;
-    ES3_KVCO is the elementary slope contribution generated by the third SV module; and,
-    ESN_KVCO is the elementary slope contribution generated by the $N^{th}$ SV module.

In other words, the combination of all elementary slope contributions is of additive nature.

For the needs of simplicity of the drawing only one varactor unit is represented for each SV module shown in FIG.4. However, each SV module may comprise several varactor units. In one example as shown in FIG.4, a varactor unit may comprise two variable MOS capacitors connected in series and a dual paths switch arranged between the two variable MOS capacitors, as will be detailed below.

A variable MOS capacitor may be obtained, for instance, by using a MOS transistor controlled in small signals mode. The respective capacitor values of both MOS capacitors in a varactor unit are identical one to the other, and each varactor unit has the same characteristics as the other varactor units of the same and of the other SV modules.

The switch of each SV module is adapted to apply either the output voltage VTune of the CP module 106 smoothed by the LF module, or a DC voltage VComp, thereby controlling the elementary slope contribution of the SV module according to the number of varactors units present therein. For instance, module SV1 has an elementary slope contribution ES1_KVCO equal to 10MHz/V, the number of varactor units being 8*1+2, *i.e.* it having 10 varactor units. Module SV2 has an elementary slope contribution ES2_KVCO equal to 10MHz/V, the number of varactor unist being 8*1+2, *i.e.* 10 varactor units. Finally, module SV3 has an elementary slope contribution ES3_KVCO equal to 20MHz/V, the number of varactor unit being 8*2+4, *i.e.* 20 varactor units.

As illustrated on the right hand side of FIG.4, when only module SV1 is activated, the overall slope S_KVCO is equal to 10MHz/V. When both modules SV1 and SV2 are activated, the overall slope S_KVCO is equal to 20MHz/V. Finally, when all three modules SV1, SV2 and SV3 are activated, the overall slope S_KVCO is equal to 40MHz/V.

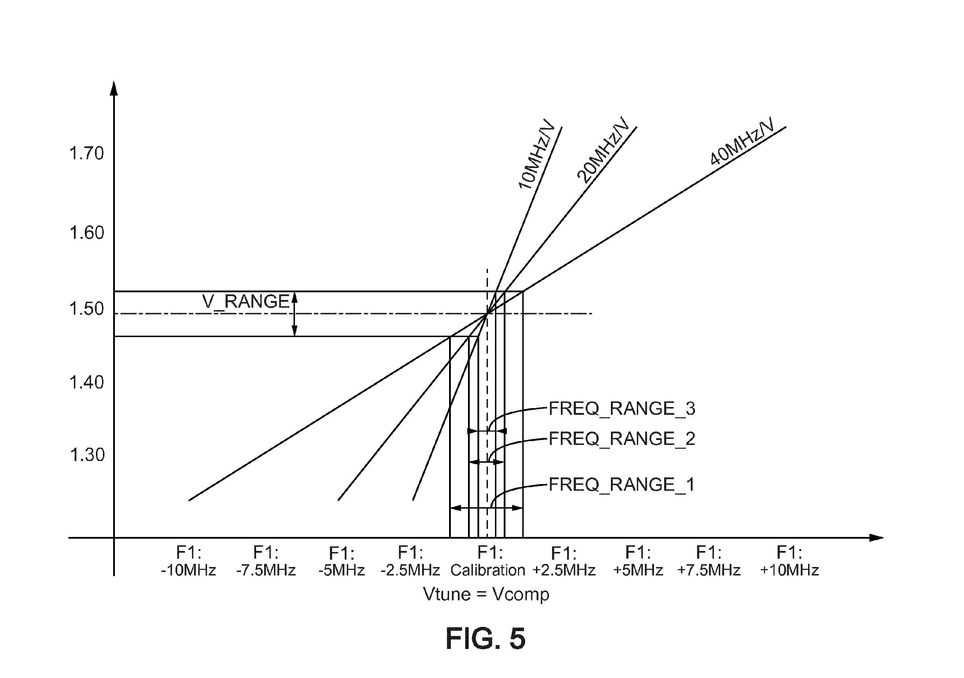

The technical effect of activating one or more of the SV modules SV1, SV2 and SV3 is illustrated, by way of example only, by the diagram of **FIG.5.**

Fig.6 shows the frequency response of the VCO module 110 (on the horizontal axis) as a function of the control voltage VTune (on the vertical axis). In the situation as shown in FIG.2, the PLL circuits is operated in a calibration phase, wherein control voltage VTune is forced to the DC voltage VComp as shown in FIG.4, of, e.g., 1.5 Volts (V).

As can be derived from FIG.5, a same range of variation V_RANGE of the control voltage VTune around the DC voltage VComp generates variations of the output frequency of the VCO module 110 (and thus of the PLL circuit 1), which depends on the slope S_KVCO of said VCO module 110: the higher the slope, the larger the frequency range around a central frequency F1.

A method of a fast lock PLL based on KVCO sequence is further proposed herein, and will now be described with reference to the timing diagram of **FIG.6.**

In order to illustrate the KVCO sequence according to proposed embodiments, the timing diagram of FIG.6 is divided in four phases of operation. It will be appreciated that the timing values on the diagrams are examples arbitrarily chosen to illustrate the explanation, and are not limiting the scope of the embodiments.

A first phase of operation 61 immediately follows the start-up of the PLL circuit 1 or any frequency change of the reference clock signal F_REF/D at the input of the PLL, which occurs at instant R0. During this first phase 61, there is performed a calibration of the PLL circuit. In the shown example, the duration of this calibration phase 61 is 10 μs.

In a second phase of operation 62 corresponds to a phase acquisition mode of the PLL where the LF module 108 is activated in its wide bandwidth mode of operation by setting the switch S1 of FIG.3 in the OFF state. Said phase 62 enables to achieve fast lock of the PLL circuit 1, but with a large frequency error between the two input signals of the Phase/frequency comparator 106, generated by the RC module 102 and FD module 104, and by FSFD module 112, respectively. The duration of this second phase is 15 μs.

A third phase 63 corresponds to the performance of the KVCO sequence itself, and therefore it will be described in greater details below. Said KVCO sequence is performed with the LF module 108 being in wide bandwidth mode and the duration of this phase 63 is 5 μs.

The last phase 64 starts with the switching of the LF module 108 in the narrow bandwidth mode of operation, and allows the output of the VCO module 110 to subsequently follow any variation of the input signal with a very small phase error.

Further, this second mode of the LF module 108 enables to decrease significantly the phase/frequency noise at the output of the PLL circuit 1.

For the sake of better understanding it will now be considered that the phases 61 and 62 described above are completed and the PLL is locked, but with a maximum phase error as explained above.

Only the third phase 63 will be described below with reference to the timing diagram of **FIG.7** which is a zoom of FIG.6 on phase 63. Further, it is recalled that the LF module 108 is in wide bandwidth mode during phase 63 and performance of all the KVCO sequence.

Furthermore, we consider the non limiting example of circuitry of the KVCO module 1102 having three SV modules as described above with reference to FIG.4 and FIG.5.

In order to illustrate the phase 63 of the phase error correction sequence according to a proposed embodiment, the timing diagram of FIG.7 is divided in e.g. six steps.

In e.g. three first steps 71 to 73 forming a first part of the phase error correction sequence, for instance, the ICP current used in the CP module is kept constant to e.g. K times an elementary charge pump current Io, that is to say to Kxlo. In the shown example, K is equal to 64. The regulation of the phase error between the two input signals of comparator module 106 is only made by modifying the slope of frequency response of the VCO module 110. This enables a maximum range of variation of the magnitude of the control signal VTune of the VCO module 110 as a function of the phase error between the two input signals of the comparator module 106. This method will be described in details below.

The next e.g. three steps 74 to 76 form a second part of phase 63 and allow obtaining additional adjustment of the frequency of the output signal of the VCO module 110, and possibly a finer phase tuning of the PLL. This is achieved by progressively varying the ICP current used in the comparator module 106, e.g. in three steps in the example considered here.

Let us first concentrate on the first part of the phase error correction sequence run during phase 63, which comprises steps of switching the KVCO value of the VCO module 110.

In a first step 71, fast phase/frequency convergence of the PLL may be privileged by selecting the maximal slope of the KVCO module, namely by activating all of the three SV modules SV1, SV2 and SV3 as shown in FIG.4 with the effect as illustrated in FIG.5, and by having the maximum charge pump current value ICP=64xlo (referred to, for better convenience, as "x64" in FIG.7). Therefore, the first slope value KVCO for performing a first coarse correction of the phase error is the slope with the highest slope value, namely 40MHz/V in the example considered here. Said maximal KVCO slope value allows obtaining a prompt variation of the phase of the output signal of the VCO module 110, given the maximal frequency range FREQ-RANGE_1 as shown in FIG.5. Indeed, at the beginning of the third phase 63, the PLL is locked to the desired frequency but a maximal phase error exists. Therefore, it is necessary to have a maximal frequency range in order to remain locked and it is necessary to have a smoothed output voltage to avoid phase/frequency noise at the output of the VCO module 110 or even, in the worst case, an unlocking of the PLL structure. For instance, as shown in FIG.6, the frequency range is 1.65 MHz for an input variation signal of the KVCO module equal to appreciatively 0.15 V. The duration of this step is approximately 0.8 $\mu$s.

At the beginning of the second step 72 of the KVCO sequence a smaller phase error exists between the two input signals of the comparator module 106. Hence, the range of the frequency variations can be decreased for controlling the frequency of the output signal of the DVCO with more accuracy. In order to achieve this, the slope value of the KVCO module can be changed. In the shown example, the slope value is varied to become e.g. 20 MHz/V. This new KVCO slope value is obtained by disabling the SV module SV3. This new value of the KVCO slope will allow obtaining a more accurate control of the output signal of the DVCO module, thus allowing a further reduction in the phase error. The duration of this step 72 is approximately 0.8 $\mu$s.

At the last step 73 of the three first steps of the phase 63, the KVCO slope is switched to a new, still lower value equal to 10 MHz/V. This KVCO slope value is obtained by further disabling the SV module SV2. In the shown example, step 73 lasts an additional time still approximately equal to 0.8 $\mu$s.

The above described first part of the KVCO sequence, which is comprised of steps 71 to 73 as described above, allows obtaining a fast but rough correction of the phase error between. This is mainly because the maximum value of the charge pump current ICP has been used, which results in promptly reducing the phase error with a high frequency response of the VCO (high KVCO slope value) yielding in coarse phase error correction.

The second portion of the phase 73 of the KVCO sequence, which allows obtaining a finer correction of the phase error in the PLL circuit 1, can then be performed.

Indeed, let us now consider the second part of sequence, which is based on the controlled variation, and more precisely the reduction, of the ICP current used in the phase/frequency comparator module 106.

What is achieved with such variation is a change in the control signal VTune input to the VCO module 110. At the end of the first part of the KVCO sequence, the PLL circuit 1 is locked with a some residual phase error and because this residual phase error is small compared to the phase error at the beginning of the KVCO sequence it is not necessary to keep the maximal charge pump current ICP. Nevertheless, it is advantageous to reduce the ICP current progressively, in order to avoid any frequency jumps which, in a worst case, could even cause an unlocking of the PLL.

For that, the amplification gain will be divided by a factor of two during three steps 74, 75 and 76 each having the same duration of again approximately 0.8 $\mu$s, as shown in FIG.7. The value of the ICP current at the end of the first part of the sequence is x64 (meaning that ICP=64xlo). At the beginning of the first step 74, of the second part of the KVCO sequence, the value of the amplification gain is divided by two and is value thus becomes 32 (meaning that ICP=32xlo). Then at the beginning of the next step 75, the ICP current is divided by two again so that its new value is x16 (meaning that ICP=16xlo). Finally, for the last step 76 of this second part of the KVCO sequence, the ICP current is once more divided by two, and its value is therefore equal to 8 (meaning that ICP=8xlo).

At the end of step 76, which is also the end of the phase error correction sequence 63, the LF module 108 is set into its narrow bandwidth mode of operation. This may be achieved, in the example as shown in FIG.3, by controlling the switch S1 in the ON state, thereby short-circuiting the resistor R2. After approximately 20 $\mu$s of additional time, namely after a total of 50 $\mu$s has lapsed since the start-up or resetting of the PLL circuit 1, said PLL circuit 1 can be considered as locked in frequency and phase.

The method of phase error correction as described above enables the VCO module 110 to have a very good sensitivity while reducing the phase error noise.

Further, reducing the ICP current value to a minimum value equal to 8 times the elementary current value Io, allows decreasing the influence of the mismatch current of the phase/frequency comparator module 106, compared with schemes known in the art wherein the ICP current is reduced to as low a value as one time Io. It could be observed that the reduction of the phase error noise due to the charge pump mismatch which is achieved that way amounts to ca. 9dB.

It will be appreciated, however, that the second part of the phase error correction sequence, namely the ICP switching, is not compulsory and has been described only because it helps improving the phase error noise reduction obtained by the proposed KVCO switching performed during the first part of the sequence. Also, as already made clear in the above, the scope of the proposed idea is not limited by the number of steps, i.e., the number of KVCO slope values taken into account in the described embodiments.

It should be understood, more generally, that the invention is not intended to be limited by specific embodiments described herein.

Indeed, while there has been illustrated and described what are presently considered to be the preferred embodiments of the present invention, it will be understood by those skilled in the art that various other modifications may be made, and equivalents may be substituted, without departing from the true scope of the present invention. Additionally, many modifications may be made to adapt a particular situation to the teachings of the present invention without departing from the central inventive concept described herein. Furthermore, an embodiment of the present invention may not include all of the features described above.

Also, expressions such as "comprise", "include", "incorporate", "contain", "is" and "have" are to be construed in a non-exclusive manner when interpreting the description and its associated claims, namely construed to allow for other items or components which are not explicitly defined also to be present. Reference to the singular is also to be construed in be a reference to the plural and vice versa.

To summarize, it is intended that the present invention be not limited to the particular embodiments disclosed, but that the invention include all embodiments falling within the scope of the appended claims.

**Claims**

1.  A Phase-Locked-Loop, PLL, integrated circuit (1), comprising:

    - a Voltage-Controlled Oscillator, VCO module (110), adapted to generate an output signal of the PLL structure having an output frequency with respect to a VCO control signal (208),
    - a frequency divider adapted to generate a feedback signal (212) from the output signal, said feedback signal having a divided frequency with respect to the output frequency,
    - a reference clock generator (102-104) adapted to generate a reference clock signal (204) with a reference frequency,
    - a phase/frequency comparator and CP (106) having:

        - a first input for receiving the reference clock signal (204) from the reference clock generator,
        - a second input for receiving the feedback signal (212) from the frequency divider,
        - an output adapted to generate a frequency error signal (206) with respect to a frequency error between the reference clock signal and the feedback signal,
        - a loop filter (108) adapted to generate a VCO control signal (208) suitable for controlling the VCO, with respect to the frequency error signal,

    wherein:

        - the loop filter is adapted to be operated in a first mode of operation wherein the loop filter has a wider frequency bandwidth and then in a second mode of operation wherein the loop filter has a narrower frequency bandwidth, and,
        - the VCO comprises a setting module (1102) adapted to set a slope of a frequency response of the VCO to a first slope value in a first step of the first mode of operation of the loop filter, and at least to a second slope value in a second step of the first mode of operation of the loop filter, said second step coming after, i.e. following said first step in a phase error reduction sequence, and said second slope value being lower than said first slope value.

2.  The PLL circuit of claim 1, wherein the setting module of the VCO comprises at least one Switchable Varactor, SV, module which is activated in the first step of the phase error reduction sequence and is disabled in the second step of the phase error reduction sequence.

3.  The PLL circuit of claim 2, wherein the setting module of the VCO comprises a plurality of SV modules connected in parallel, and wherein said SV modules are all activated in the first step of the phase error reduction sequence and are progressively disabled in respective subsequent steps of the phase error reduction sequence.

4.  The PLL circuit of claim 2, wherein each SV module comprises:

    - two variable capacitors connected in series or in parallel,
    - a dual paths switch arranged between the two variable capacitors, said switch being adapted to apply either the output voltage of the loop filter module or a DC voltage thereby controlling the activation or disablement of the SV module.

5.  The PLL device according to any one of claims 1 to 4, wherein the loop filter module (108) comprises at least one first capacitor (C1) connected in parallel with at least one RC module comprising:

    - at least a first resistor (R1) and second resistor (R2) connected in series with at least one second capacitor (C2); and,
    - at least one controllable switch (S1) arranged in parallel with the second resistor, and controlled to be in the ON state in the first mode of operation of the loop filter module and to be in the OFF state in the second mode of operation of the loop filter module.

6. The PLL circuit of any one of claims 1 to 5, wherein the phase/frequency comparator comprises a charge pump module (106).

7. The PLL device of claim 6, further comprising means for reducing a charge pump current in the first mode of operation of the loop filter after the slope of the frequency response of the VCO has reached a minimum value in said first mode of operation of the loop filter.

**FIG. 1**

**FIG. 6**

FIG. 2

FIG. 3

FIG. 7

FIG. 4

**FIG. 5**

EP 2 814 176 A1

Europäisches
Patentamt

European
Patent Office

Office européen
des brevets

## EUROPEAN SEARCH REPORT

Application Number

EP 13 30 5780

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 189 351 A2 (TEXAS INSTRUMENTS INC [US]) 20 March 2002 (2002-03-20) | 1-4 | INV. H03L7/099 |
| Y | * paragraph [0020] - paragraph [0024]; figures 1,5 * | 5-7 | H03L7/10 H03L7/107 |
| | ----- | | |
| Y | US 2004/169563 A1 (ABBASI SAEED [US] ET AL) 2 September 2004 (2004-09-02) * paragraph [0035] - paragraph [0036]; figures 2,6 * | 5-7 | |
| | ----- | | |
| A | US 2011/080196 A1 (WANG YAO-CHI [TW] ET AL) 7 April 2011 (2011-04-07) * abstract; figures 4,5 * | 1-7 | |
| | ----- | | |

TECHNICAL FIELDS
SEARCHED      (IPC)

H03L

The present search report has been drawn up for all claims

| Place of search | Date of completion of the search | Examiner |
|---|---|---|
| The Hague | 31 October 2013 | Beasley-Suffolk, D |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

...................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 13 30 5780

This annex lists the patent family members relating to the patent documents cited in the above-mentioned European search report.
The members are as contained in the European Patent Office EDP file on
The European Patent Office is in no way liable for these particulars which are merely given for the purpose of information.

31-10-2013

| Patent document cited in search report | | Publication date | Patent family member(s) | | | Publication date |
|---|---|---|---|---|---|---|
| EP 1189351 | A2 | 20-03-2002 | AT | 343870 | T | 15-11-2006 |
| | | | DE | 60124050 | T2 | 29-03-2007 |
| | | | EP | 1189351 | A2 | 20-03-2002 |
| | | | JP | 2002118460 | A | 19-04-2002 |
| | | | US | 2002036545 | A1 | 28-03-2002 |
| US 2004169563 | A1 | 02-09-2004 | NONE | | | |
| US 2011080196 | A1 | 07-04-2011 | TW | 201114186 | A | 16-04-2011 |
| | | | US | 2011080196 | A1 | 07-04-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7940129 B
- US 8149065 B